# EUROPEAN PATENT SPECIFICATION

(11) **EP 2 873 095 B1**
(45) Date of publication and mention of the grant of the patent: **14.06.2017**
(21) Application number: 12880921.7
(22) Date of filing: 11.07.2012
(51) Int. Cl.: H01L 23/48, H01L 23/12

(54) **SEMICONDUCTOR SECURED TO SUBSTRATE VIA HOLE IN SUBSTRATE**
AUF EINEM SUBSTRAT MITTELS EINES DURCHGANGSLOCHS IN DEM SUBSTRAT GESICHERTER HALBLEITER
SEMI-CONDUCTEUR FIXÉ SUR UN TROU D'INTERCONNEXION DE SUBSTRAT DANS UN SUBSTRAT

(43) Date of publication of application: 20.05.2015
(73) Proprietor: Hewlett-Packard Development Company, L.P., Houston, TX 77070 (US)
(72) Inventor: WU, Jennifer, Corvallis, Oregon 97330-4239 (US); ZHANG, Zhuqing, Corvallis, Oregon 97330-4239 (US); DINGMAN, Wallace Andrew, Corvallis, Oregon 97330-4239 (US)
(74) Representative: Zimmermann, Tankred Klaus
(86) International application number: PCT/US2012/046263
(87) International publication number: WO 2014/011167

(56) References cited:
- JP-A- H 088 388
- JP-A- 2000 304 638
- JP-A- 2009 068 882
- JP-A- 2010 036 280
- US-A1- 2008 284 041
- US-A1- 2010 207 218
- US-A1- 2012 086 116

## Description

### Background

Micro-electromechanical systems (MEMS) include miniaturized mechanical and electromechanical elements that are made using microfabrication techniques. The physical dimensions of MEMS devices vary from well below one micron to several millimeters. Also, MEMS devices vary from relatively simple structures having no moving elements to extremely complex electromechanical systems having multiple moving elements under the control of integrated electronics. Functional elements of MEMS devices include miniaturized structures, micro-electronics, and micro-sensors and micro-actuators that convert energy from one form to another, such as a measured mechanical signal into an electrical signal. MEMS devices include pressure sensors, accelerometers, gyroscopes, microphones, digital mirror displays, and micro fluidic devices. MEMS devices can be very sensitive to changes in critical dimensions of the devices and to physical orientation of the devices.

Typically, MEMS accelerometers behave like a damped mass on a spring. When an accelerometer experiences acceleration, the mass is displaced to the point that the spring is able to accelerate the mass at the same rate as the casing. This displacement is measured to give the acceleration. Piezoelectric, piezoresistive, and capacitive components can be used to convert the mechanical motion into an electrical signal.

Some MEMS accelerometers include a proof mass and electrodes that face each other across a small gap. On one side of the gap are rotor electrodes arrayed on the proof mass or rotor. On the other side of the gap are stator electrodes or fixed electrodes, facing the moving rotor electrodes across the gap. Under the influence of external accelerations, the proof mass deflects from its neutral position and the capacitance between the rotor electrodes and the stator or fixed electrodes can be measured to determine the acceleration.

US 2010/207218 A1 describes a method of manufacturing an electronic component device, which includes the steps of preparing a wiring substrate, which includes a silicon substrate, a concave portion provided on its upper surface side, a through hole formed to penetrate the silicon substrate on a bottom surface side of the concave portion, an insulating layer formed on the silicon substrate, a penetration electrode constructed by a lower conductor portion formed to a halfway position of a height direction from a bottom portion of the through hole and a connection metal member (indium layer) formed on the lower conductor portion in the through hole, and an electronic component having a terminal metal member (gold bump) on a lower surface side, and softening the connection metal member of the wiring substrate in a heating atmosphere and then sticking the terminal metal member of the electronic component into the connection metal member and connecting thereto.

US 2012/086116 A1 describes an electronic component device which includes a substrate, an electrode post made of a metal material, provide to stand on the substrate, and an electronic component whose connection electrode is connected to the electrode post, wherein the connection electrode of the electronic component and the electrode post are joined by an alloy layer including a metal which is different from the metal material of the electrode post.

US 2008/284041 A1 describes, in a semiconductor package, an electrode which has a first part extending through a semiconductor substrate and a second part extending from the first part through a compositional layer to reach a conductive pad.

### Brief Description of the Drawings

Figure 1 is a diagram illustrating one example of a device that reduces stress to a semiconductor secured to a substrate.
Figure 2 is a diagram illustrating one example of a MEMS accelerometer.
Figure 3A is a cross-section diagram illustrating one example of a device that includes a semiconductor secured to a substrate via adhesive in a hole of the substrate.
Figure 3B is a top-view diagram illustrating the substrate of the device of Figure 3A.
Figure 4A is a cross-section diagram illustrating one example of a device that includes a semiconductor secured to a substrate via adhesive in a hole and recess of the substrate.
Figure 4B is a top-view diagram illustrating the substrate of the device of Figure 4A.
Figure 5 is a top-view diagram illustrating one example of a substrate that includes multiple holes.
Figure 6 is a diagram illustrating one example of a substrate that can be used to make each of the example substrates of Figures 3A, 3B, 4A, 4B, and 5.
Figure 7A is a cross-section diagram illustrating one example of a substrate that includes a hole.
Figure 7B is a cross-section diagram illustrating one example of a device including a semiconductor secured to a substrate via adhesive in the hole.
Figure 8A is a cross-section diagram illustrating one example of a substrate including a hole and a recess.
Figure 8B is a cross-section diagram illustrating one example of a device including a semiconductor secured to a substrate via adhesive in the hole and the recess.

### Detailed Description

In the following detailed description, reference is made to the accompanying drawings which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims. It is to be understood that features of the various embodiments described herein may be combined with each other, unless specifically noted otherwise.

Some MEMS accelerometers are made by bonding together two separate semiconductor wafers on which electrodes reside facing each other across a small gap. On one side of the gap, rotor electrodes are arrayed on the moving structure referred to as the proof mass or rotor, where the proof mass is connected to the semiconductor die through a set of flexures defined by a semiconductor etching process, such as a Bosch deep silicon etch. On the other side of the gap, stator or fixed electrodes face the moving rotor electrodes. The gap between the rotor electrodes and the stator electrodes is defined by wafer bonding, and the scale factor of the accelerometer is very sensitive to this stator-rotor gap. In one example, the gap between the rotor electrodes and the stator electrodes is less than 2 micrometers (um).

In packaging of a MEMS device, a MEMS is attached to a substrate. Stress is produced in the MEMS via temperature changes due to the difference in the coefficient of thermal expansion (CTE) of the semiconductor material of the MEMS, such as silicon's CTE of 3 parts per million per degree Celcius (ppm/°C), and the CTE of the substrate, such as an organic substrate's CTE of 18 ppm/°C or a ceramic substrate's CTE of 7-9 ppm/°C. This differential thermal mechanical stress can distort the MEMS so as to alter the critical stator-rotor gap, which affects the sensor's scale factor and/or displaces the proof mass in the sensing axis and affects the sensor's bias offset. Minimizing variations in these performance parameters is an important goal in packaging a MEMS accelerometer. In addition, the stresses can be large enough to damage the MEMS.

Another deviation that can be introduced in packaging a MEMS device is the tilt of the MEMS relative to the substrate. The functionality of a MEMS accelerometer depends on the sensing axis direction or physical orientation relative to gravitational pull. Sometimes, the non-uniform thickness of die attach adhesive introduces tilt resulting in an unknown deviation in the sensing axis.

A changing scale factor with respect to temperature can be addressed via temperature calibration. The scale factor can be measured at multiple temperatures after assembly and a calibration curve established. Then, the temperature can be sensed by methods, such as an on-chip thermal sense resistor (TSR), and the scale factor corrected via the calibration curve. However, temperature calibration adds cost, and if the scale factor is not linear within the operating temperature of the device, calibration requires more than two temperature points, which could be cost-prohibitive. In addition, hysteresis and stress relaxation in many adhesives and substrates can produce a time and history dependent stress, which limits the effectiveness of temperature calibration.

Ceramic substrates can be used instead of organic substrates, such as FR4, to minimize the thermal mechanical stress. However, even though the amount of change in scale factor and bias offset with temperature is smaller when using a ceramic substrate, it is not eliminated. Also, ceramic substrates are more expensive than organic substrates.

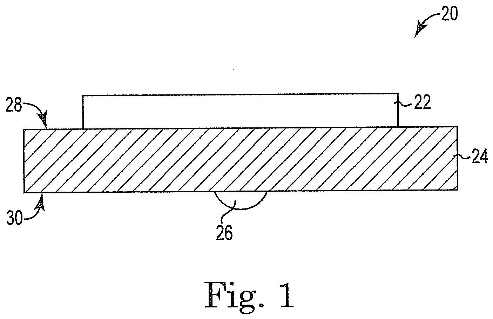

Figure 1 is a diagram illustrating one example of a device 20 that reduces stress to a semiconductor 22 that is secured or attached to a substrate 24. The tilt of semiconductor 22 relative to substrate 24 is reduced or substantially eliminated, such that semiconductor 22 and substrate 24 are parallel to one another. Semiconductor 22 is secured to substrate 24 via an adhesive 26. In one example, semiconductor 22 is a MEMS device. In one example, substrate 24 has a lower modulus of elasticity than semiconductor 22. In one example, substrate 24 is an organic substrate. In one example, substrate 24 is FR4. In another example, substrate 24 is a ceramic substrate. In one example, semiconductor 22 is attached to substrate 24 via a die attach adhesive.

Substrate 24 includes at least one hole (not shown in Figure 1) that extends through substrate 24 from one surface 28 of substrate 24 to another surface 30 of substrate 24, where the one surface 28 of substrate 24 opposes the other surface 30 of substrate 24. In one example, the at least one hole is milled and/or drilled through substrate 24.

Adhesive 26 is situated in the at least one hole and attached to semiconductor 22 at the one surface 28 of substrate 24. Adhesive 26 is substantially coplanar with the one surface 28 and extends out of the one or more holes and onto the other surface 30 of substrate 24. Semiconductor 22 is secured to substrate 24 via adhesive 26 through the at least one hole. In another example, adhesive 26 is in the one or more holes and flush or coplanar with the other surface 30 of substrate 24. In another example, adhesive 26 is in the one or more holes and concave in the one or more holes with respect to the other surface 30 of substrate 24.

Attaching semiconductor 22 to substrate 24 via the one or more holes in substrate 24 reduces the surface area of semiconductor 22 attached to substrate 24 and reduces stress between semiconductor 22 and substrate 24, as compared to attaching semiconductor 22 to substrate 24 via adhesive on a larger area of semiconductor 22, such as between substantially all of one surface of semiconductor 22 and the one surface 28 of substrate 24. Also, semiconductor 22 is supported by the one surface 28, which eliminates or reduces tilt between semiconductor 22 and substrate 24.

In one example, substrate 24 has multiple holes that extend through substrate 24 from the one surface 28 to the other surface 30, and semiconductor 22 is secured to substrate 24 via adhesive 26 in each of the multiple holes.

In one example, substrate 24 has a hole that intersects a recess at the one surface 28. The recess is larger than the hole and semiconductor 22 is supported by the one surface 28 at the perimeter of the recess. In one example, adhesive 26 is in the hole and at least part of the recess. In one example, substrate 24 is milled and/or drilled to provide the hole and/or the recess in substrate 24.

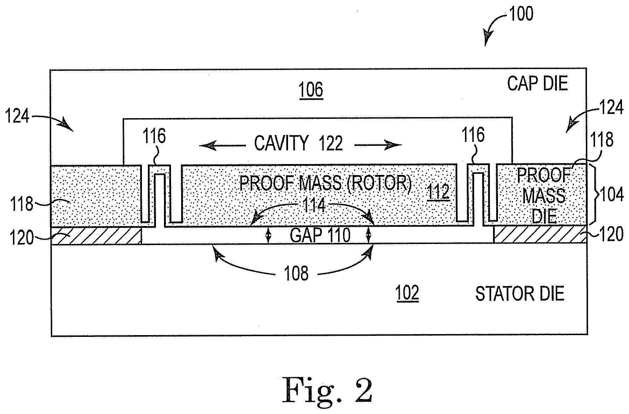

Figure 2 is a diagram illustrating one example of a MEMS 100 that is an accelerometer. MEMS 100 includes a stator die 102, a proof mass die 104, and a cap die 106. In one example, semiconductor 22 (shown in Figure 1) is MEMS 100.

Stator die 102 includes stator or fixed electrodes on stator die face 108, which faces the stator-rotor gap 110 and proof mass 112. Stator die 102 is a semiconductor die, such as silicon, that is processed to provide the stator or fixed electrodes on stator die face 108.

Proof mass die 104 includes the proof mass or rotor 112 that includes rotor electrodes arrayed on proof mass face 114, which faces the stator-rotor gap 110 and the stator or fixed electrodes on stator die face 108 of stator die 102. Proof mass die 104 is a semiconductor die, such as silicon, that is processed to provide the rotor electrodes on proof mass face 114. Proof mass die 104 also includes flexures 116 attached to proof mass 112 and to perimeter portions 118 of proof mass die 104. The flexures 116, which connect proof mass 112 to proof mass die 104, are defined by a semiconductor etching process, such as a Bosch deep silicon etch. In one example, flexures 116 are springs.

Proof mass die 104 is bonded to stator die 102 via bonding material 120, which defines the stator-rotor gap 110 between proof mass 112 and stator die 102. The stator-rotor gap 110 is the gap between the rotor electrodes on proof mass 112 and the stator electrodes on stator die 102. The scale factor of MEMS accelerometer 100 is sensitive to this stator-rotor gap 110. In one example, the stator-rotor gap 110 is less than 2 um. In one example, stator die 102 is one of many stator die on a stator wafer and proof mass die 104 is one of many proof mass die on a proof mass wafer, and the proof mass wafer is bonded to the stator wafer in a wafer level bonding process.

Cap die 106 includes a cavity 122 and rim 124. Cap die 106 is a semiconductor die, such as silicon, that is processed to provide cavity 122 and rim 124. Cavity 122 is positioned over proof mass 112 and flexures 116. Rim 124 is attached to perimeter portions 118 of proof mass die 104 via wafer bonding. In one example, proof mass die 104 is one of many proof mass die on a proof mass wafer and cap die 106 is one of many cap die on a cap wafer that is fixedly attached to the proof mass wafer in a wafer level process.

In operation, proof mass 112 is displaced in relation to stator die 102 as MEMS 100 experiences acceleration. Rotor electrodes on proof mass face 114 are displaced with regard to the stator or fixed electrodes on stator die face 108. Proof mass 112 is displaced to the point that flexures 116 are able to accelerate proof mass 112 at the same rate as stator die 102 and cap die 106. The displacement of proof mass 112 is measured to give the acceleration.

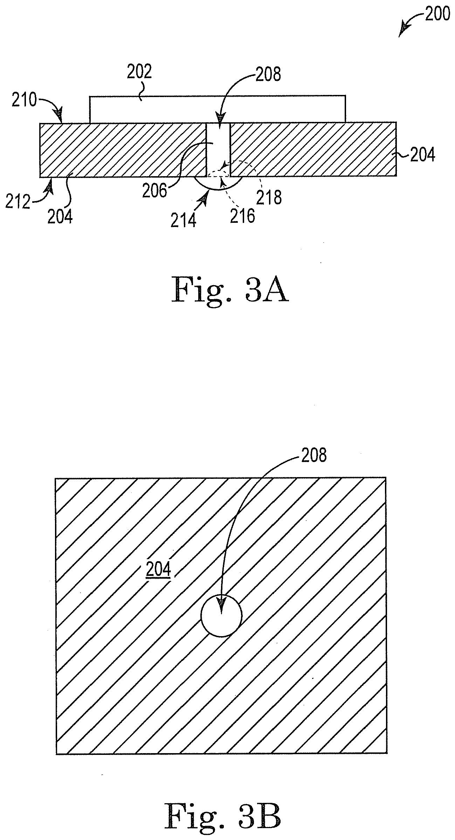

Figure 3A is a cross-section diagram illustrating one example of a device 200 that includes a semiconductor 202 secured or attached to a substrate 204. Semiconductor 202 is secured to substrate 204 via an adhesive 206 in hole 208 of substrate 204. In one example, device 20 of Figure 1 is similar to device 200. In one example, semiconductor 202 is similar to semiconductor 22 (shown in Figure 1). In one example, semiconductor 202 is similar to MEMS 100 of Figure 2. In one example, semiconductor 202 is 7 millimeters (mm) by 7 mm square.

Hole 208 of substrate 204 extends from one surface 210 of substrate 204 to another surface 212 of substrate 204, where the one surface 210 of substrate 204 opposes the other surface 212 of substrate 204. In one example, substrate 204 has a lower modulus of elasticity than semiconductor 202. In one example, substrate 204 is an organic substrate. In one example, substrate 204 is FR4. In another example, substrate 204 is a ceramic substrate.

Adhesive 206 is situated in hole 208 and attached to semiconductor 202 at the one surface 210 of substrate 204. Adhesive 206 is substantially coplanar with the one surface 210 and, at 214, extends out of hole 208 and onto the other surface 212 of substrate 204. Semiconductor 202 is secured to substrate 204 via adhesive 206 in hole 208. In another example, at 216, adhesive 206 is in hole 208 and flush or coplanar with the other surface 212 of substrate 204. In another example, at 218, adhesive 206 is in hole 208 and concave with respect to the other surface 212 of substrate 204. In one example, adhesive 206 is a die attach adhesive.

Attaching semiconductor 202 to substrate 204 via adhesive 206 in hole 208 reduces the surface area of semiconductor 202 attached to substrate 204 and reduces stress between semiconductor 202 and substrate 204, as compared to attaching semiconductor 202 to substrate 204 via adhesive on a larger area of semiconductor 202, such as between substantially all of one surface of semiconductor 202 and the one surface 210 of substrate 204. Also, semiconductor 202 is supported by the one surface 210 of substrate 204, which eliminates or reduces tilt between semiconductor 202 and substrate 204.

In another example, substrate 204 has multiple holes that extend through substrate 204 from the one surface 210 to the other surface 212, and semiconductor 202 is secured to substrate 204 via adhesive 206 in one or more of the multiple holes.

Figure 3B is a top-view diagram illustrating substrate 204 of device 200. Substrate 204 includes hole 208 in the center of substrate 204. In one example, hole 208 is 1-3 mm in diameter. In one example, hole 208 is milled and/or drilled through substrate 204. In one example, substrate 24 (shown in Figure 1) is substrate 204.

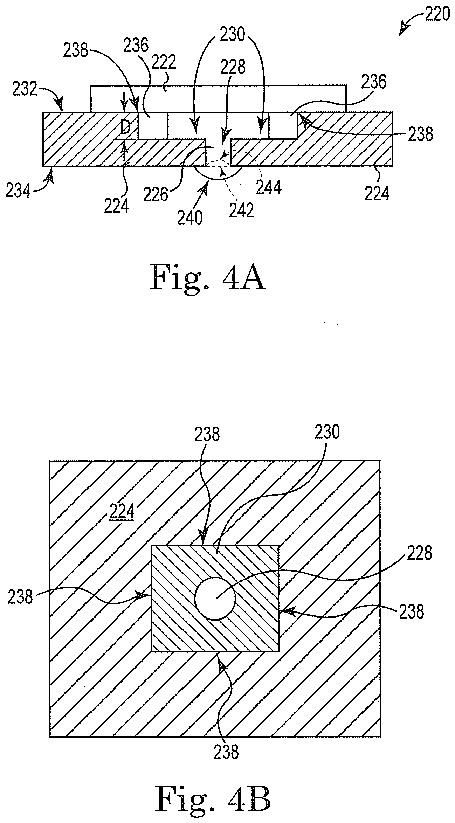

Figure 4A is a cross-section diagram illustrating one example of a device 220 that includes a semiconductor 222 secured or attached to a substrate 224. Semiconductor 222 is secured to substrate 224 via an adhesive 226 in a hole 228 and recess 230 of substrate 224. In one example, device 20 of Figure 1 is similar to device 220. In one example, semiconductor 222 is similar to semiconductor 22 (shown in Figure 1). In one example, semiconductor 222 is similar to MEMS 100 of Figure 2. In one example, semiconductor 222 is 7 millimeters (mm) by 7 mm square.

Substrate 224 has recess 230 at one surface 232. Hole 228 intersects recess 230 and extends (including recess 230) from the one surface 232 to another surface 234 of substrate 224, where the one surface 232 of substrate 224 opposes the other surface 234 of substrate 224. Recess 230 has a depth D from the one surface 232 to the floor of recess 230. In one example, the depth D of recess 230 is between 50 and 300 um. In one example, substrate 224 has a lower modulus of elasticity than semiconductor 222. In one example, substrate 224 is an organic substrate. In one example, substrate 224 is FR4. In another example, substrate 224 is a ceramic substrate.

Adhesive 226 is situated in hole 228 and in recess 230 and attached to semiconductor 222 at the one surface 232 of substrate 224. Adhesive 226 is substantially coplanar with the one surface 232 and, at 240, extends out of hole 228 and onto the other surface 234 of substrate 224. Space 236 is left on one or more sides of adhesive 226, between adhesive 226 and perimeter 238 of recess 230. This space 236 permits expansion/contraction of adhesive 226 in recess 230, without affecting the positional relationship between semiconductor 222 and substrate 224. Semiconductor 222 is secured to substrate 224 via adhesive 226 in hole 228 and in recess 230, which limits the thickness of adhesive 226 in the recess 230 to the depth D of recess 230. In another example, at 242, adhesive 226 is in hole 228 and flush or coplanar with the other surface 234 of substrate 224. In another example, at 244, adhesive 226 is in hole 228 and concave with respect to the other surface 234 of substrate 224. In one example, adhesive 226 is a die attach adhesive.

Attaching semiconductor 222 to substrate 224 via adhesive 226 in hole 228 and in recess 230 reduces the surface area of semiconductor 222 attached to substrate 224 and reduces stress between semiconductor 222 and substrate 224, as compared to attaching semiconductor 222 to substrate 224 via adhesive on a larger area of semiconductor 222, such as between substantially all of one surface of semiconductor 222 and the one surface 232 of substrate 224. Also, semiconductor 222 is supported by the one surface 232 of substrate 224 at perimeter 238 of recess 230, which eliminates or reduces tilt between semiconductor 222 and substrate 224. In addition, attaching semiconductor 222 to substrate 224 via adhesive 226 in hole 228 and in recess 230 controls the thickness of adhesive 226.

In another example, substrate 224 has multiple holes that intersect recess 230 and extend through substrate 224 from the one surface 232 to the other surface 234, and semiconductor 222 is secured to substrate 224 via adhesive 226 in one or more of the multiple holes and recess 230.

Figure 4B is a top-view diagram illustrating substrate 224 of device 220. Substrate 224 includes hole 228 and recess 230 situated in the center of substrate 224. In one example, hole 228 is 1-3 mm in diameter. In one example, hole 228 is milled and/or drilled through substrate 224. In one example, recess 230 is milled and/or drilled in substrate 224. In one example, substrate 24 (shown in Figure 1) is substrate 224.

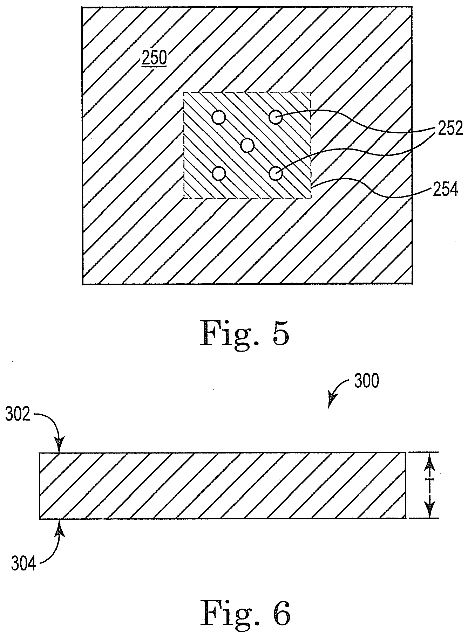

Figure 5 is a top-view diagram illustrating one example of a substrate 250 that includes multiple holes 252. Adhesive, such as adhesive 206 or 226, can be put in one or more of the multiple holes 252 and attached to a semiconductor, such as semiconductor 202 or 222. In another example, the multiple holes 252 intersect a recess 254 (indicated in dashed lines) and adhesive, such as adhesive 206 or 226, can be put in one or more of the multiple holes 252 and recess 254 and attached to a semiconductor, such as semiconductor 202 or 222. In one example, the multiple holes 252 are milled and/or drilled through substrate 250. In one example, recess 254 is milled and/or drilled in substrate 250. In one example, substrate 24 (shown in Figure 1) is substrate 250.

Figure 6 is a diagram illustrating one example of a substrate 300 that can be used to make each of the example substrates of: 204 (shown in Figures 3A and 3B), 224 (shown in Figures 4A and 4B), and 250 (shown in Figure 5). In one example, substrate 24 (shown in Figure 1) is made from substrate 300.

Substrate 300 includes a first surface 302 and a second surface 304 that opposes the first surface 302. Substrate 300 has a thickness T from the first surface 302 to the second surface 304. In one example, thickness T of substrate 300 is about 1.6 mm.

Substrate 300 is an organic substrate. In one example, substrate 300 is FR4. In another example, substrate 300 is a ceramic substrate.

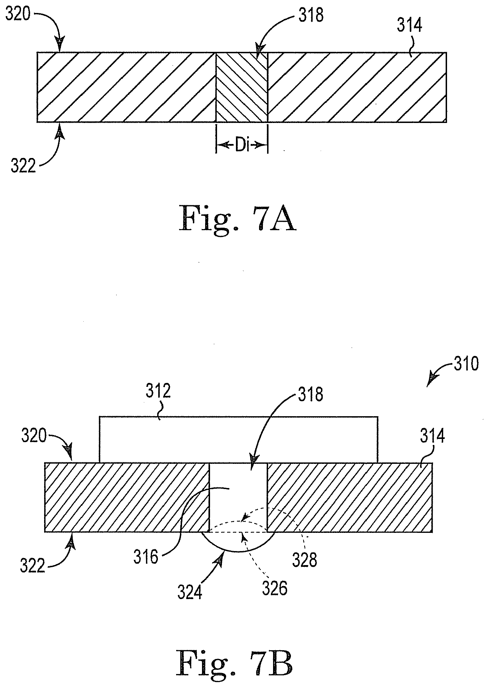

Figures 7A and 7B are diagrams illustrating a method of assembling a device 310 that includes a semiconductor 312 secured or attached to a substrate 314 via an adhesive 316. In one example, semiconductor 312 is similar to MEMS 100 of Figure 2. In one example, device 310 is similar to device 20 of Figure 1.

Figure 7A is a cross-section diagram illustrating one example of substrate 314, which is formed from substrate 300 of Figure 6. Substrate 300 is processed or formed to provide hole 318 in substrate 314. In one example, substrate 300 is drilled to provide hole 318 in substrate 314. In one example, substrate 314 is similar to substrate 204 (shown in Figures 3A and 3B). In one example, substrate 24 (shown in Figure 1) is substrate 314.

Hole 318 of substrate 314 extends from a first surface 320 of substrate 314 to a second surface 322 of substrate 314, where first surface 320 opposes second surface 322. Hole 318 has diameter Di. In one example, hole 318 is in the center of substrate 314. In one example, hole 318 has a diameter Di of 1-3 mm.

Figure 7B is a cross-section diagram illustrating one example of device 310, where semiconductor 312 is secured to substrate 314 via adhesive 316 in hole 318. In one example, adhesive 316 is applied at first surface 320 of substrate 314 and semiconductor 312 is pushed onto adhesive 316, such that adhesive 316 pushes into hole 318. In another example, semiconductor 312 is placed in contact with first surface 320 of substrate 314 and adhesive 316 is applied through the backside of substrate 314 from second surface 322 to at least partially fill hole 318.

Adhesive 316 is situated in hole 318 and attached to semiconductor 312 at the plane of first surface 320 of substrate 314. Adhesive 316 is substantially coplanar with first surface 320 and attached to semiconductor 312. At 324, adhesive 316 extends out of hole 318 and onto second surface 322 of substrate 314. Semiconductor 312 is secured to substrate 314 via adhesive 316 in hole 318. In another example, at 326, adhesive 316 is in hole 318 and flush or coplanar with second surface 322 of substrate 314. In another example, at 328, adhesive 316 is in hole 318 and concave with respect to second surface 322 of substrate 314. In one example, adhesive 316 is a die attach adhesive.

Semiconductor 312 is supported by substrate 314 at first surface 320. Semiconductor 312 is not directly attached to first surface 320. Semiconductor 312 is attached to adhesive 316 in hole 318. This secures or attaches semiconductor 312 to substrate 314. Supporting semiconductor 312 with the first surface 320 reduces or eliminates tilt between semiconductor 312 and substrate 314.

Attaching semiconductor 312 to substrate 314 via adhesive 316 in hole 318 reduces the surface area of semiconductor 312 attached to substrate 314 and reduces stress between semiconductor 312 and substrate 314. Also, semiconductor 312 is supported by the one surface 320 of substrate 314, which eliminates or reduces tilt between semiconductor 312 and substrate 314.

In another example, substrate 314 has multiple holes that extend through substrate 314 from the first surface 320 to the second surface 322, and semiconductor 312 is secured to substrate 314 via adhesive 316 in one or more of the multiple holes.

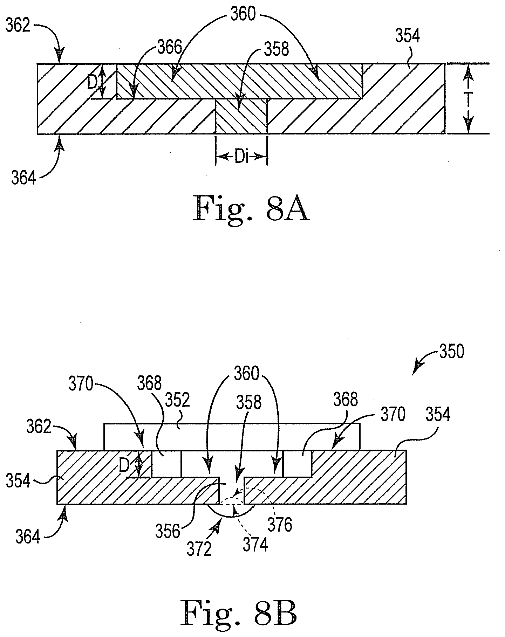

Figures 8A and 8B are diagrams illustrating a method of assembling a device 350 that includes a semiconductor 352 secured or attached to a substrate 354 via an adhesive 356. In one example, semiconductor 352 is similar to MEMS 100 of Figure 2. In one example, device 350 is similar to device 20 of Figure 1.

Figure 8A is a cross-section diagram illustrating one example of substrate 354, which is formed from substrate 300 of Figure 6. Substrate 300 is processed or formed to provide hole 358 and recess 360 in substrate 354. In one example, substrate 300 is milled and/or drilled to provide hole 358 and/or recess 360 in substrate 354. In one example, substrate 354 is similar to substrate 224 (shown in Figures 4A and 4B). In one example, substrate 24 (shown in Figure 1) is substrate 354.

Substrate 354 has recess 360 at first surface 362. Recess 360 has a depth D from first surface 362 to floor 366 of recess 360. Hole 358 intersects recess 360 and extends (including recess 360) from first surface 362 to second surface 364 of substrate 354, where first surface 362 opposes second surface 364. Hole 358 has a diameter Di in the portion of hole 358 from floor 366 of recess 360 to second surface 364. In one example, hole 358 and recess 360 are in the center of substrate 354. In one example, hole 358 has a diameter Di of 1-3 mm in the portion from floor 366 to second surface 364. In one example, recess 360 is rectangular. In one example, recess 360 is oblong. In one example, recess 360 is circular. In one example, the depth D of recess 360 is between 50 and 300 um.

Figure 8B is a cross-section diagram illustrating one example of device 350, where semiconductor 352 is secured to substrate 354 via adhesive 356 in hole 358 and recess 360. In one example, adhesive 356 is applied at first surface 362 of substrate 354 and semiconductor 352 is pushed onto adhesive 356, such that adhesive 356 pushes into recess 360 and hole 358. In another example, semiconductor 352 is placed in contact with first surface 362 of substrate 354 and adhesive 356 is applied through the backside of substrate 354 from second surface 364 to at least partially fill hole 358 and recess 360.

Adhesive 356 is applied into hole 358 and recess 360. Adhesive 356 is attached to semiconductor 352 at the plane of first surface 362 of substrate 354. Adhesive 356 is substantially coplanar with first surface 362 and attached to semiconductor 352. At 372, adhesive 356 extends out of hole 358 and onto second surface 364 of substrate 354. Space 368 is on one or more sides of adhesive 356, between adhesive 356 and perimeter 370 of recess 360. This space 368 in recess 360 permits expansion/contraction of adhesive 356 in recess 360, without affecting the positional relationship between semiconductor 352 and substrate 354. Semiconductor 352 is secured to substrate 354 via adhesive 356 in hole 358 and in recess 360. The thickness of adhesive 356 in recess 360 is limited to the depth D of recess 360. In another example, at 374, adhesive 356 is in hole 358 and flush or coplanar with second surface 364 of substrate 354. In another example, at 376, adhesive 356 is in hole 358 and concave with respect to second surface 364 of substrate 354. In one example, adhesive 356 is a die attach adhesive.

Semiconductor 352 is supported by substrate 354 at the perimeter 370 of recess 360. Semiconductor 352 is not directly attached to first surface 362. Semiconductor 352 is attached to adhesive 356 in hole 358 and recess 360. This secures or attaches semiconductor 352 to substrate 354. Supporting semiconductor 352 with first surface 362 reduces or eliminates tilt between semiconductor 352 and substrate 354.

Attaching semiconductor 352 to substrate 354 via adhesive 356 in hole 358 and in recess 360 reduces the surface area of semiconductor 352 attached to substrate 354 and reduces stress between semiconductor 352 and substrate 354. Also, semiconductor 352 is supported by first surface 362 at perimeter 370 of recess 360, which eliminates or reduces tilt between semiconductor 352 and substrate 354. In addition, attaching semiconductor 352 to substrate 354 via adhesive 356 in hole 358 and in recess 360 controls the thickness of adhesive 356.

In another example, substrate 354 has multiple holes that intersect recess 360 and extend through substrate 354 from first surface 362 to second surface 364, and semiconductor 352 is secured to substrate 354 via adhesive 356 in one or more of the multiple holes and recess 360.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A device comprising:
a semiconductor (22, 100, 202, 222, 312, 352); and
a substrate (24, 204, 224, 250, 314, 354) having a first surface (28, 210, 232, 302, 320, 362) and a second surface (30, 212, 234, 304, 322, 364) that opposes the first surface (28, 210, 232, 302, 320, 362), wherein the substrate (24, 204, 224, 250, 314, 354) has a hole (208, 228, 252, 318, 358) that extends from the first surface (28, 210, 232, 302, 320, 362) to the second surface (30, 212, 234, 304, 322, 364) and the semiconductor (22, 100, 202, 222, 312, 352) is secured to the substrate (24, 204, 224, 250, 314, 354) via adhesive in the hole (208, 228, 252, 318, 358),
wherein the adhesive is attached to the semiconductor (22, 100, 202, 222, 312, 352) at one surface thereof.

2. The device of claim 1, wherein the adhesive is substantially coplanar with the first surface (28, 210, 232, 302, 320, 362).

3. The device of claim 1, wherein the semiconductor (22, 100, 202, 222, 312, 352) is supported by the first surface (28, 210, 232, 302, 320, 362) to reduce tilt between the semiconductor (22, 100, 202, 222, 312, 352) and the substrate (24, 204, 224, 250, 314, 354).

4. The device of claim 1, wherein the substrate (224, 354) has a recess (230, 360) that is larger than the hole (228, 358) at the first surface (232, 362) and the semiconductor (222, 352) is supported by the first surface (232, 362) at a perimeter around the recess (230, 360).

5. The device of claim 4, wherein the hole (228, 358) intersects the recess (230, 360) and the adhesive is in the hole (228, 358) and at least part of the recess (230, 360).

6. The device of claim 1, wherein the substrate (250) has multiple holes (252) and each of the multiple holes (252) extends from the first surface (302) to the second surface (304).

7. The device of claim 6, wherein the semiconductor is secured to the substrate (250) with the adhesive in each of the multiple holes (252).

8. The device of one of claims 1 to 7, wherein the semiconductor (22, 100, 202, 222, 312, 352) comprises a MEMS device.

9. A method of assembling a device comprising:
providing a semiconductor (22, 100, 202, 222, 312, 352);
providing a substrate (24, 204, 224, 250, 314, 354) having a first surface (28, 210, 232, 302, 320, 362) and a second surface (30, 212, 234, 304, 322, 364) that opposes the first surface (28, 210, 232, 302, 320, 362);
forming a hole (208, 228, 252, 318, 358) in the substrate (24, 204, 224, 250, 314, 354), wherein the hole (208, 228, 252, 318, 358) extends from the first surface (28, 210, 232, 302, 320, 362) to the second surface (30, 212, 234, 304, 322, 364); and
securing the semiconductor (22, 100, 202, 222, 312, 352) to the substrate (24, 204, 224, 250, 314, 354) via adhesive in the hole (208, 228, 252, 318, 358),
wherein the adhesive is attached to the semiconductor (22, 100, 202, 222, 312, 352) at one surface thereof.

10. The method of claim 9, wherein securing the semiconductor (22, 100, 202, 222, 312, 352) comprises one of:
applying the adhesive from the first surface (28, 210, 232, 302, 320, 362) of the substrate (24, 204, 224, 250, 314, 354) and pushing the semiconductor (22, 100, 202, 222, 312, 352) into the adhesive; and
applying the adhesive from the second surface (30, 212, 234, 304, 322, 364) of the substrate (24, 204, 224, 250, 314, 354) to at least partially fill the hole (208, 228, 252, 318, 358).

11. The method of claim 9, wherein securing the semiconductor (22, 100, 202, 222, 312, 352) comprises:
supporting the semiconductor (22, 100, 202, 222, 312, 352) with the first surface (28, 210, 232, 302, 320, 362) to reduce tilt between the semiconductor (22, 100, 202, 222, 312, 352) and the substrate (24, 204, 224, 250, 314, 354).

12. The method of claim 9, comprising:
forming a recess (230, 360) that is larger than the hole (228, 358) at the first surface (232, 362), wherein securing the semiconductor (222, 352) comprises supporting the semiconductor (222, 352) via a perimeter around the recess (230, 360).

13. The method of claim 12, wherein securing the semiconductor (22, 100, 202, 222, 312, 352) comprises:
attaching the semiconductor (222, 352) to the substrate (224, 354) via adhesive in the hole (228, 358) and at least part of the recess (230, 360).

## Patentansprüche

1. Vorrichtung, Folgendes umfassend:
einen Halbleiter (22, 100, 202, 222, 312, 352); und
ein Substrat (24, 204, 224, 250, 314, 354) mit einer ersten Oberfläche (28, 210, 232, 302, 320, 362) und einer zweiten Oberfläche (30, 212, 234, 304, 322, 364), die der ersten Oberfläche (28, 210, 232, 302, 320, 362) gegenüberliegt, wobei das Substrat (24, 204, 224, 250, 314, 354) ein Loch (208, 228, 252, 318, 358) aufweist, das sich von der ersten Oberfläche (28, 210, 232, 302, 320, 362) zu der zweiten Oberfläche (30, 212, 234, 304, 322, 364) hin erstreckt und der Halbleiter (22, 100, 202, 222, 312, 352) über einen Klebstoff in dem Loch (208, 228, 252, 318, 358) an dem Substrat (24, 204, 224, 250, 314, 354) gesichert ist,
wobei der Klebstoff an dem Halbleiter (22, 100, 202, 222, 312, 352) an einer Oberfläche davon gesichert ist.

2. Vorrichtung nach Anspruch 1, wobei der Klebstoff im Wesentlichen mit der ersten Oberfläche (28, 210, 232, 302, 320, 362) koplanar ist.

3. Vorrichtung nach Anspruch 1, wobei der Halbleiter (22, 100, 202, 222, 312, 352) auf der ersten Oberfläche (28, 210, 232, 302, 320, 362) gelagert ist, um eine Neigung zwischen dem Halbleiter (22, 100, 202, 222, 312, 352) und dem Substrat (24, 204, 224, 250, 314, 354) zu verringern.

4. Vorrichtung nach Anspruch 1, wobei das Substrat (224, 354) eine Aussparung (230, 360), die größer ist als das Loch (228, 358), an der ersten Oberfläche (232, 362) aufweist und der Halbleiter (222, 352) auf der ersten Oberfläche (232, 362) an einem Umfang um die Aussparung (230, 360) herum gelagert ist.

5. Vorrichtung nach Anspruch 4, wobei das Loch (228, 358) die Aussparung (230, 360) schneidet und Klebstoff sich in dem Loch (228, 358) und an wenigstens einem Teil der Aussparung (230, 360) befindet.

6. Vorrichtung nach Anspruch 1, wobei das Substrat (250) mehrere Löcher (252) aufweist und jedes der mehreren Löcher (252) sich von der ersten Oberfläche (302) bis hin zu der zweiten Oberfläche (304) erstreckt.

7. Vorrichtung nach Anspruch 6, wobei der Halbleiter mit dem Klebstoff in jedem der mehreren Löcher (252) an dem Substrat (250) gesichert ist.

8. Vorrichtung nach einem der Ansprüche 1 bis 7, wobei der Halbleiter (22, 100, 202, 222, 312, 352) eine MEMS-Vorrichtung umfasst.

9. Verfahren zum Zusammensetzen einer Vorrichtung, Folgendes umfassend:
Bereitstellen eines Halbleiters (22, 100, 202, 222, 312, 352);
Bereitstellen eines Substrats (24, 204, 224, 250, 314, 354) mit einer ersten Oberfläche (28, 210, 232, 302, 320, 362) und einer zweiten Oberfläche (30, 212, 234, 304, 322, 364) die der ersten Oberfläche (28, 210, 232, 302, 320, 362) gegenüberliegt;
Ausbilden eines Lochs (208, 228, 252, 318, 358) in dem Substrat (24, 204, 224, 250, 314, 354), wobei das Loch (208, 228, 252, 318, 358) sich von der ersten Oberfläche (28, 210, 232, 302, 320, 362) bis zu der zweiten Oberfläche (30, 212, 234, 304, 322, 364) erstreckt; und
Sichern des Halbleiters (22, 100, 202, 222, 312, 352) an dem Substrat (24, 204, 224, 250, 314, 354) über Klebstoff in dem Loch (208, 228, 252, 318, 358),
wobei der Klebstoff an dem Halbleiter (22, 100, 202, 222, 312, 352) an einer Oberfläche davon gesichert ist.

10. Verfahren nach Anspruch 9, wobei das Sichern des Halbleiters (22, 100, 202, 222, 312, 352) eines der Folgenden umfasst:
Auftragen des Klebstoffs von der ersten Oberfläche (28, 210, 232, 302, 320, 362) des Substrats (24, 204, 224, 250, 314, 354) und Drücken des Halbleiters (22, 100, 202, 222, 312, 352) in den Klebstoff; und
Auftragen des Klebstoffs von der zweiten Oberfläche (30, 212, 234, 304, 322, 364) des Substrats (24, 204, 224, 250, 314, 354), um das Loch (208, 228, 252, 318, 358) wenigstens teilweise zu füllen.

11. Verfahren nach Anspruch 9, wobei das Sichern des Halbleiters (22, 100, 202, 222, 312, 352) Folgendes umfasst:
Lagern des Halbleiters (22, 100, 202, 222, 312, 352) auf der ersten Oberfläche (28, 210, 232, 302, 320, 362), um eine Neigung zwischen dem Halbleiter (22, 100, 202, 222, 312, 352) und dem Substrat (24, 204, 224, 250, 314, 354) zu verringern.

12. Verfahren nach Anspruch 9, Folgendes umfassend:
Ausbilden einer Aussparung (230, 360), die größer ist als das Loch (228, 358), an der ersten Oberfläche (232, 362), wobei das Sichern des Halbleiters (222, 352) das Lagern des Halbleiters (222, 352) über einen Umfang um die Aussparung (230, 360) herum umfasst.

13. Verfahren nach Anspruch 12, wobei das Sichern des Halbleiters (22, 100, 202, 222, 312, 352) Folgendes umfasst:
Befestigen des Halbleiters (222, 352) an dem Substrat (224, 354) über einen Klebstoff in dem Loch (228, 358) und wenigstens einen Teil der Aussparung (230, 360).

## Revendications

1. Dispositif comprenant :
un semiconducteur (22, 100, 202, 222, 312, 352) ; et
un substrat (24, 204, 224, 250, 314, 354) ayant une première surface (28, 210, 232, 302, 320, 362) et une seconde surface (30, 212, 234, 304, 322, 364) qui est opposée à la première surface (28, 210, 232, 302, 320, 362), dans lequel le substrat (24, 204, 224, 250, 314, 354) comporte un trou (208, 228, 252, 318, 358) qui s'étend de la première surface (28, 210, 232, 302, 320, 362) à la seconde surface (30, 212, 234, 304, 322, 364) et le semiconducteur (22, 100, 202, 222, 312, 352) est attaché au substrat (24, 204, 224, 250, 314, 354) par de l'adhésif dans le trou (208, 228, 252, 318, 358),
dans lequel l'adhésif est attaché au semiconducteur (22, 100, 202, 222, 312, 352) sur une surface de celui-ci.

2. Dispositif selon la revendication 1, dans lequel l'adhésif est sensiblement coplanaire à la première surface (28, 210, 232, 302, 320, 362).

3. Dispositif selon la revendication 1, dans lequel le semiconducteur (22, 100, 202, 222, 312, 352) est soutenu par la première surface (28, 210, 232, 302, 320, 362) afin de réduire l'inclinaison entre le semiconducteur (22, 100, 202, 222, 312, 352) et le substrat (24, 204, 224, 250, 314, 354).

4. Dispositif selon la revendication 1, dans lequel le trou (224, 354) possède une cavité (230, 360) qui est plus grande que le trou (228, 358) sur la première surface (232, 362) et le semiconducteur (222, 352) est soutenu par la première surface (232, 362) sur un périmètre autour de la cavité (230, 360).

5. Dispositif selon la revendication 4, dans lequel le trou (228, 358) fait la jonction entre la cavité (230, 360) et l'adhésif qui est dans le trou (228, 358) et au moins une partie de la cavité (230, 360).

6. Dispositif selon la revendication 1, dans lequel le substrat (250) a de multiple trous (252) et chacun des multiples trous (252) s'étend de la première surface (302) à la seconde surface (304).

7. Dispositif selon la revendication 6, dans lequel le semiconducteur est attaché au substrat (250) avec l'adhésif qui est dans chacun des multiples trous (252).

8. Dispositif selon l'une quelconque des revendications 1 à 7, dans lequel le semiconducteur (22, 100, 202, 222, 312, 352) comprend un dispositif MEMS.

9. Procédé d'assemblage de dispositif comprenant :
la fourniture d'un semiconducteur (22, 100, 202, 222, 312, 352) ;
la fourniture d'un substrat (24, 204, 224, 250, 314, 354) ayant une première surface (28, 210, 232, 302, 320, 362) et une seconde surface (30, 212, 234, 304, 322, 364) qui est opposée à la première surface (28, 210, 232, 302, 320, 362) ;
la formation d'un trou (208, 228, 252, 318, 358) dans le substrat (24, 204, 224, 250, 314, 354), dans lequel le trou (208, 228, 252, 318, 358) s'étend de la première surface (28, 210, 232, 302, 320, 362) à la seconde surface (30, 212, 234, 304, 322, 364) ; et
la sécurisation du semiconducteur (22, 100, 202, 222, 312, 352) au substrat (24, 204, 224, 250, 314, 354),
dans lequel l'adhésif est attaché au semiconducteur (22, 100, 202, 222, 312, 352) sur une surface de celui-ci.

10. Procédé selon la revendication 9, dans lequel la sécurisation du semiconducteur (22, 100, 202, 222, 312, 352) comprend une des étapes suivantes :
l'application de l'adhésif depuis la première surface (28, 210, 232, 302, 320, 362) du substrat (24, 204, 224, 250, 314, 354) et la poussée du semiconducteur (22, 100, 202, 222, 312, 352) dans l'adhésif; et
l'application de l'adhésif de la seconde surface (30, 212, 234, 304, 322, 364) du substrat (24, 204, 224, 250, 314, 354) afin de remplir au moins partiellement le trou (208, 228, 252, 318, 358).

11. Procédé selon la revendication 9, dans lequel la sécurisation du semiconducteur (22, 100, 202, 222, 312, 352) comprend :
le soutien du semiconducteur (22, 100, 202, 222, 312, 352) avec la première surface (28, 210, 232, 302, 320, 362) afin de réduire l'inclinaison entre le semiconducteur (22, 100, 202, 222, 312, 352) et le substrat (24, 204, 224, 250, 314, 354).

12. Procédé selon la revendication 9 comprenant :
la formation d'une cavité (230, 360) qui est plus grande que le trou (228, 358) sur la première surface (232, 362), dans lequel la sécurisation du semiconducteur (222, 352) comprend le soutien du semiconducteur (232, 352) par un périmètre autour de la cavité (230, 360).

13. Procédé selon la revendication 12, dans lequel la sécurisation du semiconducteur (22, 100, 202, 222, 312, 352) comprend :
la fixation du semiconducteur (222, 352) au substrat (224, 354) avec de l'adhésive dans le trou (228, 358) et au moins une partie de la cavité (230,360).
